# FASCICULE DE BREVET EUROPEEN

(11) **EP 3 714 669 B1**
(45) Date de publication et mention de la délivrance du brevet: **28.07.2021**
(21) Numéro de dépôt: 18816198.8
(22) Date de dépôt: 20.11.2018
(51) Int. Cl.: H05K 7/20, H05K 7/14, H01L 23/00, H01L 23/40, H01L 23/498, H01L 25/07

(54) **MODULE ELECTRONIQUE DE PUISSANCE**
LEISTUNGSELEKTRONIKMODUL
POWER ELECTRONIC MODULE

(30) Priorité: 22.11.2017 FR 1761065
(43) Date de publication de la demande: 30.09.2020
(73) Titulaire: Safran, 75015 Paris (FR)
(72) Inventeur: YOUSSEF, Toni, 77550 Moissy-Cramayel (FR); AZZOPARDI, Stéphane, Joseph, 77550 Moissy-Cramayel (FR); KHAZAKA, Rabih, 77550 Moissy-Cramayel (FR); MARTINEAU, Donatien, Henri, Edouard, 77550 Moissy-Cramayel (FR)
(74) Mandataire: Cabinet Beau de Loménie
(86) Numéro de dépôt international: PCT/FR2018/052922
(87) Numéro de publication internationale: WO 2019/102135

(56) Documents cités:
- US-A1- 2010 284 155
- US-A1- 2014 160 691
- US-B1- 6 507 108

## Description

### Arrière-plan de l'invention

L'invention a trait à la réalisation d'un module électronique de puissance présentant une haute fiabilité et une maintenabilité facilitée, notamment dans le cadre d'applications aéronautiques.

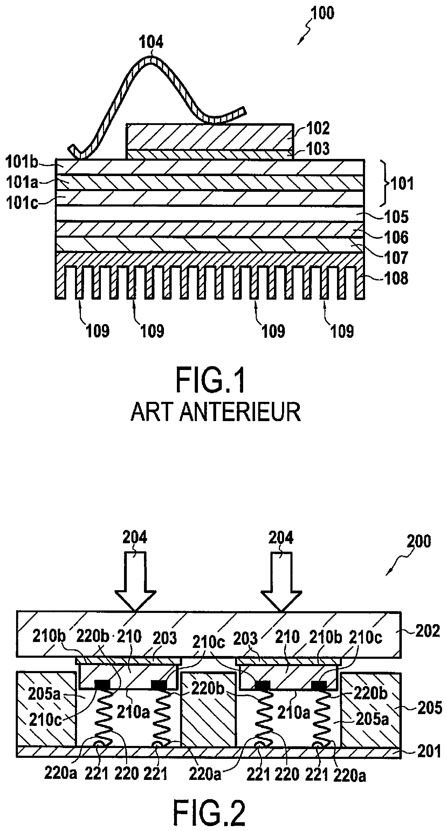

La Figure 1 illustre une structure de module 100 électronique de puissance réalisée selon l'art antérieur. Le module 100 électronique de puissance présente un substrat 101 formé d'une couche électriquement isolante 101a, en matériau céramique, agencée entre deux couches métalliques 101b, 101c. Les couches métalliques 101b, 101c peuvent être assemblées à la couche électriquement isolante 101a selon diverses techniques, par exemple par brasage AMB (« *Active Metal Brazing* »), par liaison directe de cuivre DBC (« *Direct Bonded Copper* »), ou encore par liaison directe d'aluminium DBA (« *Direct Bonded Aluminium* »). La couche métallique 101b supérieure du substrat 101 forme un circuit de puissance sur lequel un ou plusieurs composants 102 à semi-conducteur de puissance sont assemblés. Les composants 102 à semi-conducteur de puissance sont assemblés sur la couche métallique 101b par l'intermédiaire d'un joint d'interconnexion 103. Ce dernier assure un contact mécanique, électrique et thermique entre les composants 102 et la couche métallique 101b. Les composants 102 à semi-conducteur de puissance sont en outre connectés au circuit de puissance, formé par la couche 101b, par des fils de câblage métallique 104.

Du fait de leurs imperfections, les composants 102 à semi-conducteur de puissance sont le siège de pertes par effet Joule et représentent une source importante de chaleur. Ainsi, la couche métallique 101c inférieure du substrat 101 est reportée par l'intermédiaire d'un joint d'interconnexion 105 sur une semelle 106 métallique, cette dernière ayant pour rôle d'étaler le flux thermique et d'assurer une connexion thermique avec un dissipateur thermique 108 métallique. Le joint d'interconnexion 105 a pour fonction d'assurer un contact mécanique, électrique et thermique entre la couche métallique 101c et la semelle 106 métallique. La semelle 106 est elle-même assemblée par l'intermédiaire d'une couche 107 de matériau d'interface thermique au dissipateur thermique 108 métallique. La couche 107 est, à titre d'exemple, une graisse thermique, un film élastomère, ou une couche de matériaux à changement de phase. La couche 107 permet de réduire la résistance thermique de contact entre la semelle 106 et le dissipateur thermique 108 afin assurer une meilleure évacuation du flux thermique. A titre d'exemple, le dissipateur thermique 108 est muni d'ailettes 109 permettant de minimiser la résistance thermique de ce dernier, les ailettes 109 étant traversées par un fluide de refroidissement tel que de l'air.

Le module 100 électronique de puissance décrit ci-dessus présente néanmoins plusieurs inconvénients.

Premièrement, les différentes couches 101a, 101b, 101c du substrat 101, ainsi que la semelle 106, possèdent des coefficients de dilatation thermique différents entre elles rendant le module 100 sensible au phénomène de fatigue thermique. Au cours des cycles thermiques auquel est soumis le module 100 électronique de puissance, il peut ainsi apparaitre des fissures dans la couche électriquement isolante 101a du substrat 101, dans les joints d'interconnexion électrique 103, 105, et/ou dans la connexion entre les fils de câblage métallique 104 et la couche 101b. Ces risques de fissures impactent donc la fiabilité du module 100. De plus, l'utilisation de fils de câblage métallique 104 induit la présence d'inductances parasites.

En outre, le report du composant 102 à semi-conducteur de puissance par le joint d'interconnexion 103, ainsi que sa connexion par les fils de câblage métallique 104 restreignent la réparation du module 100. Le remplacement d'un composant 102 à semi-conducteur de puissance s'avère en effet très contraignant. Ceci nécessite notamment de supprimer le joint d'interconnexion 103, dé-câbler le composant 102, puis recommencer la connexion d'un nouveau composant par des fils de câblage métallique 104. Dans le cas où ces actions sont envisageables, de multiples étapes sont ainsi requises, impliquant un temps et un coût de remplacement élevé du composant, pour une réussite aléatoire. Le module 100 électronique de puissance décrit ci-dessus est donc très rarement maintenable, et une solution courante consiste à remplacer le module 100 dans son ensemble en cas de défaillance d'un composant 102.

Par ailleurs, la présence des fils de câblage métallique 104 pour raccorder chaque composant 102 limite, compte tenu de la complexité d'assemblage, l'ajout de composants supplémentaires ou le remplacement d'un composant spécifique. L'architecture du module 100 électronique de puissance limite donc l'ajout de composants supplémentaires et donc les gammes de puissances auxquelles peuvent s'appliquer le module 100.

Une autre structure de module électronique de puissance connue de l'art antérieur se rapporte à un module pressé, couramment désigné sous la dénomination « Press-Pack ». Dans cette architecture, un ou plusieurs composants à semi-conducteur de puissance se présentent sous la forme de puces nues directement insérées en sandwich entre deux couches de substrat. Cette deuxième architecture présente plusieurs avantages par rapport à celle précédemment décrite. En effet, celle-ci permet notamment de s'affranchir de fils de câblages ou de brasures, est peu sensible à la fatigue thermique et permet de réduire les inductances parasites. Cependant, les architectures de type « Press-Pack » demeurent limitées aux composants de fortes puissances (ex : thyristors, thyristors à extinction par gâchette GTO, transistors bipolaires à grille isolée IGBT). Par ailleurs, le fait de disposer les composants à semi-conducteur de puissance en sandwich entre deux couches de substrats peut conduire à l'observation d'effets piézo-résistifs indésirables sur ces composants. En outre, le montage des composants s'avère délicat et implique des coûts de fabrication élevés. Une telle solution s'avère donc elle aussi limitée.

Il est donc souhaitable de réaliser un module électronique de puissance fiable, peu sensible à la fatigue thermique, facilement maintenable, simplifiant l'ajout de de nouveaux composants, présentant un système de refroidissement simple à mettre en œuvre, ne présentant pas d'effets piézo-résistifs indésirables, applicable à toute gamme de puissance, présentant un cout de fabrication réduit et un minimum d'inductances parasites.

### Objet et résumé de l'invention

La présente invention a pour but de remédier aux inconvénients précités.

A cet effet, l'invention propose un module électronique de puissance comprenant une pluralité de composants électroniques de puissance à semi-conducteur reliés électriquement à un support électrique, et un dispositif de refroidissement en contact thermique avec chaque composant, chaque composant étant présent entre le support électrique et le dispositif de refroidissement, chaque composant étant en outre monté sur le support électrique via au moins un élément ressort électriquement conducteur.

Le module électronique de puissance décrit ci-dessus présente les avantages suivants. L'élément ressort est rétractable et permet le raccordement électrique du composant avec le support électrique. En outre, l'élément ressort exerce une pression contrôlée sur le composant, permettant de le maintenir fixe. Il est ainsi possible, vis-à-vis de l'état de l'art, de s'affranchir de l'utilisation de fils de câblage métallique ainsi que du report du composant sur des joints d'interconnexions, qui impliqueraient des inductances parasites et des risques de défaillances. La fiabilité du module électronique de puissance s'en voit donc renforcée. Par ailleurs, le contact électrique entre chaque composant et le support électrique est établi par simple mise en appui des composants sur au moins un élément ressort. Le contact mécanique et électrique entre chaque composant et un élément ressort est maintenu par une force d'appui exercée par le dispositif de refroidissement sur chaque composant. Ainsi, en cas de défaillance d'un composant spécifique, le module est facilement démontable, le composant défaillant accessible et remplaçable par simple retrait. Le module présente ainsi une haute maintenabilité. Cette haute maintenabilité du module autorise l'ajout de composants supplémentaires, ou le remplacement spécifique de composant(s) sans impliquer de complexité d'assemblage, lui conférant ainsi des propriétés modulaires. Il est ainsi possible de cibler en termes d'applications diverses gammes de puissance, notamment les applications de faibles et/ou moyennes puissances.

Dans un exemple de réalisation, chaque composant comprend une première face disposée en regard du support électrique, ladite première face comportant des électrodes, et ledit au moins un élément ressort établissant un raccord électrique entre au moins une des électrodes et le support électrique.

Dans un exemple de réalisation, chaque composant comprend une seconde face opposée à la première face et le module comprend en outre une interface thermique est disposée entre le dispositif de refroidissement et une seconde face de chaque composant.

Dans un exemple de réalisation, ledit au moins un élément ressort établissant un raccord électrique entre ladite au moins une des électrodes et le support électrique comprend une première extrémité brasée sur le support électrique.

Dans un exemple de réalisation, ledit au moins un élément ressort comprend une seconde extrémité venant en appui sur ladite au moins une des électrodes.

Dans un exemple de réalisation, chaque composant est conditionné dans un boitier électronique à montage de surface.

Dans un exemple de réalisation, un cadre de positionnement est disposé entre le support électrique et le dispositif de refroidissement et comprend des orifices traversants configurés chacun pour recevoir respectivement un composant et au moins un élément ressort.

Dans un exemple de réalisation, ledit au moins un composant est un transistor de puissance ou une diode de puissance.

Dans un exemple de réalisation, le module résumé ci-dessus comprend un convertisseur de puissance formé par une pluralité de composants.

### Brève description des dessins

D'autres caractéristiques et avantages de l'invention ressortiront de la description suivante de modes particuliers de réalisation de l'invention, donnés à titre d'exemples non limitatifs, en référence aux dessins annexés, sur lesquels :
- la figure 1 est une vue en coupe d'un module électronique de puissance réalisé selon l'état de l'art,
- la figure 2 est une vue en coupe d'un module électronique de puissance réalisé selon l'invention,
- la figure 3 illustre un exemple de circuit électronique pouvant être mis en œuvre par le module électronique de puissance réalisé selon l'invention,
- les figures 4A à 4E illustrent des vues en perspectives correspondant à des étapes d'assemblage du module électronique de puissance selon l'invention,
- la figure 5 illustre une vue en perspective, après assemblage, du module électronique de puissance selon l'invention.

### Description détaillée de modes de réalisation

La figure 2 illustre un module 200 électronique de puissance selon l'invention. Le module 200 comprend un ou plusieurs composants 210 électroniques de puissance reliés électriquement à un support électrique 201. Deux composants 210 sont ici illustrés à titre d'exemple, un tout autre nombre de composant pouvant être envisagé. Chaque composant 210 électronique de puissance est un composant de puissance à semi-conducteur, soit un transistor soit une diode. Un composant 210 électronique de puissance à semi-conducteur est à titre d'exemple un transistor à effet de champ à jonction JFET (« *Junction Field Effect Transistor*»), un transistor à effet de champ à grille isolée MOSFET (« *Metal Oxide Semiconductor Field Effect Transistor*»), un transistor à électron à hétérostructure HEMT (« *High Electron Mobility Transistor*»), une diode PIN (« *Positive Intrinsic Negative diode* ») ou encore une diode Schottky.

Le support électrique 201 est, à titre d'exemple, un substrat multicouche. Le substrat multicouche peut, à titre d'exemple, présenter une couche conductrice avec un circuit imprimé comprenant des pistes électriquement conductrices en regard du ou des composants 210, une couche conductrice intermédiaire pour la commande des composants 210 (ex : pour commander la tension de grille d'un transistor) et une couche conductrice pour la polarisation électrique des composants 210, les couches conductrices étant séparées par l'intermédiaire de couches isolantes.

Chaque composant 210 est relié électriquement au support électrique 201 par l'intermédiaire d'éléments ressort 220 électriquement conducteurs. Plus précisément, chaque composant 210 présente sur une première face 210a des électrodes 210c en regard du support électrique 201. Chaque électrode 210c peut être raccordée électriquement par un ou plusieurs éléments ressorts 220 au support électrique 201. Les éléments ressort 220 sont rétractables et autorisent le passage d'un courant avec une faible résistivité, typiquement de 10 à 15A par connecteur suivant les modèles. Une première extrémité 220a de chaque élément ressort 220 est fixée sur le support électrique 201. Dans l'exemple illustré, chaque première extrémité 220a de chaque élément ressort 220 est connectée sur le support électrique 201 par l'intermédiaire d'une brasure 221. Chaque élément ressort 220 comprend par ailleurs une seconde extrémité 220b, libre, venant via une force de rappel en appui sur au moins une électrode 210c d'un composant 210, établissant ainsi un contact électrique entre le composant 210 et le support électrique 201. En d'autres termes, chaque seconde extrémité 220b n'est pas fixée au composant 210, un simple appui entre le composant 210 et la seconde extrémité 220b permettant d'assurer le raccordement électrique du composant 210 au support électrique 201.

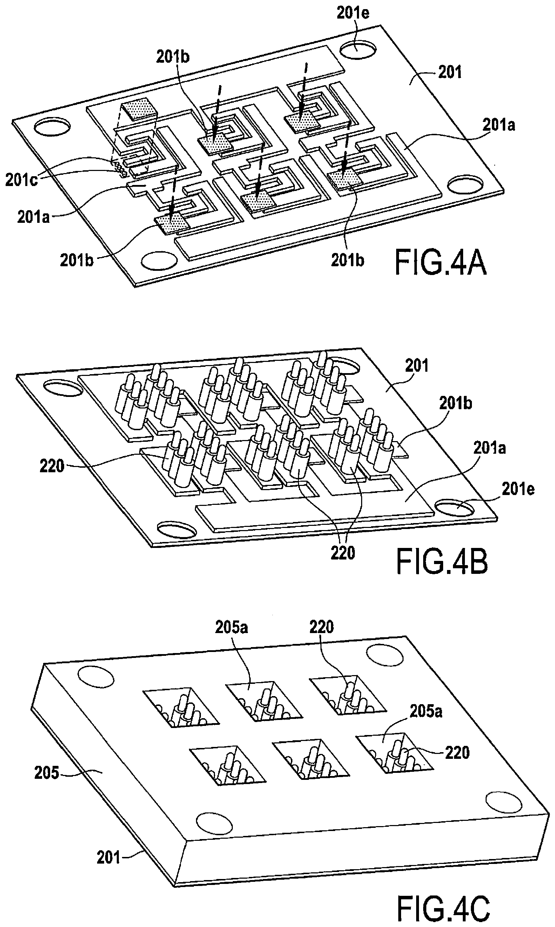

Dans les exemples illustrés sur les figures 2 et 4B à 4D, chaque élément ressort 220 électriquement conducteur est un connecteur à contact à ressort. Un tel type de connecteur est notamment fourni par la société Smiths Interconnect®. Cependant, tout élément électriquement conducteur, mécaniquement déformable et apte à exercer une force mécanique de rappel sur le composant 210 peut être utilisé en tant qu'élément ressort 220.

Chaque composant 210 électronique de puissance à semi-conducteur présente une seconde face 210b opposée à la première face 210a. La seconde face 210b de chaque composant 210 est en contact thermique avec un dispositif de refroidissement 202. Chaque composant 210 est donc présent entre le support électrique 201 et le dispositif de refroidissement 202. Le dispositif de refroidissement 202 est, à titre d'exemple, un dissipateur thermique muni d'ailettes traversées par un fluide de refroidissement tel que de l'air. Une interface thermique 203 est disposée entre chaque seconde face 210b et le dispositif de refroidissement 202 afin d'améliorer le refroidissement de chaque composant 210. La couche 203 est par exemple une graisse thermique, un film élastomère, ou encore une couche de matériaux à changement de phase permettant de réduire la résistance thermique de contact entre chaque seconde face 210b et le dispositif de refroidissement 202.

Le dispositif de refroidissement 202 exerce une force mécanique d'appui sur la seconde face 210b de chaque composant 210, de manière à maintenir indirectement en appui la première face 210a de chaque composant 210 contre une seconde extrémité 220b d'un élément ressort 220.

En vue de garantir un bon contact électrique entre chaque composant 210 et le support électrique 201, et afin d'assurer un bon contact thermique entre chaque composant 210 et le dispositif de refroidissement 202, des moyens mécaniques 204 de pression viennent compléter la force mécanique exercée par le dispositif de refroidissement 202 sur les composants 210.

Par ailleurs, en vue de garantir un bon positionnement des composants 210 sur les éléments ressorts 220, un cadre de positionnement 205 est disposé entre le support électrique 201 et le dispositif de refroidissement 202. Le cadre de positionnement 205 comprend un ou plusieurs orifices 205a traversant. Chaque orifice 205a traversant est ménagé dans le cadre de positionnement 205 pour recevoir un composant 210 ainsi que le ou les éléments ressorts 220 raccordant électriquement le composant 210 au support électrique 201.

Préférentiellement, afin d'optimiser le contact électrique entre les électrodes présentes sur la première face 210a de chaque composant 210 et le ou les éléments ressorts 220, chaque composant se présente sous la forme d'un SiP (« *System in Package*»), c'est-à-dire est conditionné dans un boitier à montage de surface. Ce conditionnement confère aux composants un positionnement des électrodes sur une seule face et une manipulation aisée par l'utilisateur. Les composants 210 packagés sont à titre d'exemple des transistors JFET en Silicium, des transistors HEMT en Nitrure de Gallium GaN et/ou des transistors MOSFET en Silicium comprenant un circuit de commande.

Le module 200 électronique de puissance décrit ci-dessus peut être mis en œuvre pour des applications de faibles et/ou moyennes puissances, notamment pour des applications aéronautiques. A titre d'exemple, différents modules 200 électroniques de puissance peuvent réaliser des fonctions de conversion de puissances utilisées pour l'électrification des systèmes non-propulsifs d'un aéronef. Ces fonctions peuvent notamment couvrir l'alimentation électrique du réseau principal de l'aéronef pour tout type de conversions de puissance: alternative vers continue (AC/DC), continue vers alternative (DC/AC), alternative vers alternative (AC/AC) ou encore continue vers continue (DC/DC).

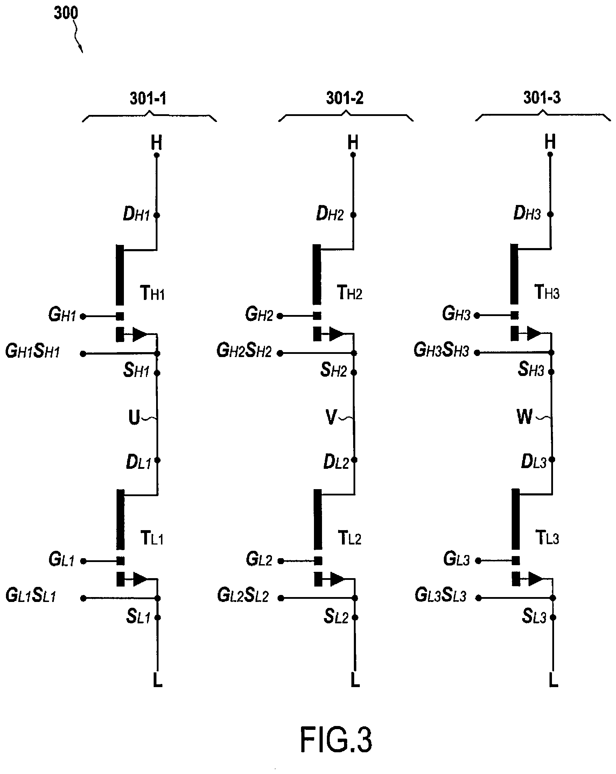

La figure 3 illustre un exemple de fonction électronique pouvant être réalisée par le module 200 électronique de puissance. Le circuit électronique illustré sur cette figure a pour fonction de convertir une énergie continue DC en énergie alternative AC via un onduleur triphasé 300. L'onduleur triphasé 300 est constitué de trois bras d'onduleur 301-i monophasés, avec i= 1, 2 ou 3, sans diode de roue libre externe. Chaque bras d'onduleur 301-i associe en tant que composants 210 électroniques de puissance à semi-conducteur deux transistors THi et TLi. Dans cet exemple, les transistors THi et TLi sont des transistors HEMT en Nitrure de Gallium et comprennent trois électrodes : un drain, une grille et une source. La fonction de roue libre est assurée par une conduction inverse du composant 210 électronique de puissance à semi-conducteur. Cependant tout autre type de composant de puissance à semi-conducteur, pouvant présenter un autre nombre d'électrodes ou similaire, peut être utilisé, en ajoutant si besoin un composant faisant office de diode de roue libre.

Chaque bras d'onduleur 301-i est ici constitué :
- d'une électrode H qui porte le potentiel haut d'un bus d'alimentation et qui est reliée au drain DHi du transistor THi,
- d'une électrode GHi qui est la grille du transistor THi, correspondant à l'électrode de commande,
- d'une électrode GHiSHi, qui correspond au potentiel de référence du signal de commande appliqué sur la grille GHi. L'électrode GHiSHi est reliée à une électrode SHi qui est la source du transistor THi,
- d'une électrode U, V ou W portant le potentiel de la charge, c'est-à-dire la sortie du bras d'onduleur 301-i. Cette électrode est reliée à la source SHi du transistor THi et au drain DLi du transistor TLi,
- d'une électrode GLi, qui est la grille du transistor TLi, correspondant à l'électrode de commande,
- d'une électrode GLiSLi, qui correspond au potentiel de référence du signal de commande appliqué sur la grille GLi, qui est reliée à l'électrode SLi,
- d'une électrode L qui porte le potentiel bas d'un bus d'alimentation et qui est reliée à la source SLi du transistor TLi.

Les trois bras d'onduleur 301-i ainsi regroupés permettent de réaliser une fonction d'onduleur triphasé 300 pour une conversion de puissance DC/AC.

Des étapes d'assemblage d'un module 200 électronique de puissance réalisant le circuit électronique décrit ci-dessus sont illustrées sur les Figures 4A à 4E.

Sur la Figure 4A, un support électrique 201 est préalablement fabriqué en vue d'assurer des fonctions de connexion et d'isolation électriques. Le support électrique 201 est à titre d'exemple un substrat céramique métallisé (ex : liaison directe de cuivre DBC, ou par liaison directe d'aluminium DBA), un substrat métallique isolé (SMI) ou un circuit imprimé (PCB).

Dans l'exemple illustré, le support électrique 201 est un circuit imprimé multicouches, présentant trois couches métalliques (ex: en cuivre ou en tout autre matériau conducteur), chaque couche métallique étant séparée par une couche d'isolant.

Une première couche métallique comprend des pistes 201a conductrices destinées à véhiculer les potentiels bas et haut de bus L, H et relier les électrodes SHi, DLi des transistors THi et TLi. Comme il peut être vu sur la figure 4A, la première couche métallique est disposée sur la surface d'une couche isolante, correspondant sur cette figure à la face visible du support électrique 201.

Une deuxième couche métallique, non-visible, est enfouie dans le support électrique 201 et a pour fonction de véhiculer les signaux de commande des transistors THi et TLi. Les première et deuxième couches métalliques étant séparées par une couche isolante, des trous métallisés (vias) traversant la couche isolante effectuent la liaison électrique entre les première et deuxième couches métalliques. Dans l'exemple illustré sur la Figure 4A, les vias se présentent sous la forme de plots 201c sur lesquels sont connectés (flèches pointillées) électriquement et mécaniquement (ex : par brasage) des circuits de commande 201b (« *Drivers*»). Les circuits de commande 201b sont en outre connectés électriquement et mécaniquement sur les pistes 201a conductrices, permettant ainsi de communiquer les signaux de commande issus de la deuxième couche métallique aux électrodes de commande des transistors THi et TLi.

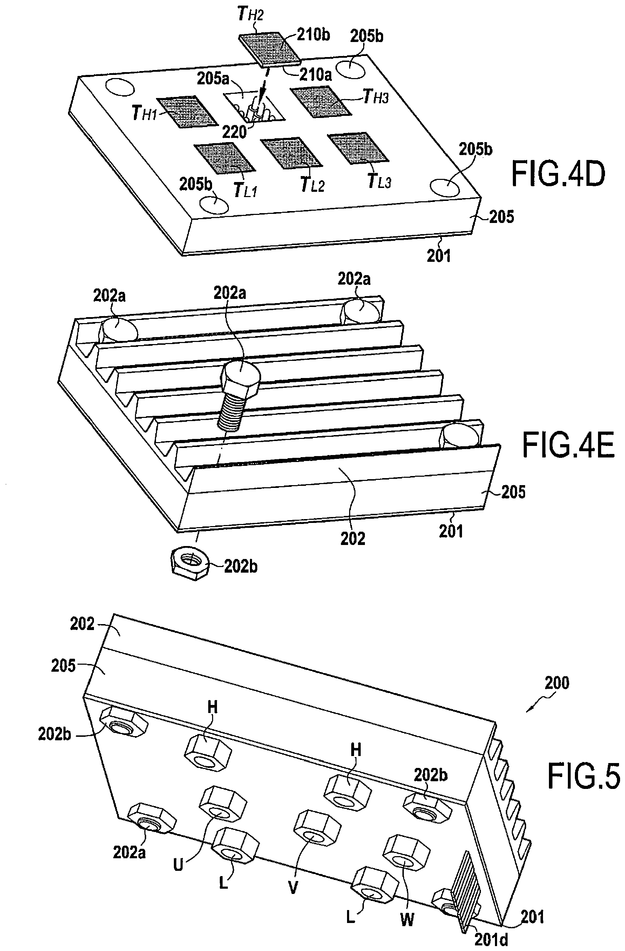

Une troisième couche métallique, non-visible, est séparée de la deuxième couche par une première couche isolante, et de l'extérieur du support électrique 201 par une seconde couche isolante. Cette seconde couche isolante correspond à la face visible du support électrique 201 illustré sur la Figure 5. La troisième couche métallique récupère par l'intermédiaire de trous métallisés (vias) traversant les différentes couches isolantes les sorties U, V et W des transistors THi et TLi en vue de les connecter à l'environnement extérieur.

La troisième couche métallique comprend en outre un connecteur peigne 201d faible puissance, visible sur la Figure 5. Ce connecteur peigne 201d constitue également un via électriquement conducteur entre les deuxième et troisième couches métalliques, et permet d'acheminer depuis l'extérieur du support électrique 201 vers la deuxième couche métallique les signaux de commande destinés aux transistors THi et TLi. Comme exposé plus haut, les signaux de commandes sont ensuite transmis par l'intermédiaire de vias électriquement conducteurs, tels les plots 201c, aux différents circuits de commande 201b, et depuis chaque circuit de commande 201b à un transistor associé.

Comme illustré sur la Figure 4B, des éléments ressorts 220 sont ensuite fixés sur la première couche du support électrique 201 de manière à établir un contact mécanique et électrique avec les pistes conductrices du PCB. Les éléments ressorts 220 peuvent être connectés électriquement et mécaniquement au support électrique 201 par brasage, collage, frittage, insertion mécanique forcée, ou tout autre moyen de fixation. Dans l'exemple illustré, les connecteurs sont brasés sur les pistes 201a conductrices et sur les circuits de commande 201b. En fonction de l'écartement des électrodes des transistors THi et TLi, plusieurs éléments ressorts 220 peuvent éventuellement être disposés de manière à être simultanément en regard d'une même électrode, optimisant ainsi le contact électrique avec cette électrode. Ainsi, dans l'exemple illustré pour les transistors THi et TLi:
- deux éléments ressort 220 sont disposés de manière à être simultanément en regard d'une électrode SHi ou SLi,
- un élément ressort 220 est disposé de manière à être en regard d'une électrode GHi, GLi, GHiSHi ou GLiSLi,
- trois éléments ressort 220 sont disposés de manière à faire face simultanément à une électrode DHi ou DLi.

Un cadre de positionnement 205 est ensuite disposé sur le support électrique 201. Comme il peut être observé sur la Figure 4C, des orifices 205a ont préalablement été ménagés dans celui-ci afin de permettre le passage des éléments ressorts 220. Chaque orifice 205a est destiné à recevoir un composant 210, ici un transistor THi ou TLi, servant ainsi de guide aux transistors THi, TLi lors de leur mise en appui sur les éléments ressorts 220. Les transistors THi, TLi sont alors chacun positionnés dans un orifice 205 et viennent en appui sur leurs éléments ressorts 220 respectifs (voir Figure 4D). Plus précisément, les électrodes de chaque première face 210a des transistors THi, TLi sont positionnées en regard de leurs éléments ressorts 220 respectifs, établissant par appui sur ces derniers un contact mécanique et électrique. La deuxième face 210b de chaque transistor THi, TLi fait alors face à l'extérieur de l'orifice 205a, cette deuxième face 210b étant destinée à être refroidie.

Un dispositif de refroidissement 202 est ensuite positionné sur le cadre de positionnement 205 de manière à venir exercer une pression sur chaque deuxième face 210b des transistors THi ou TLi. Cette pression permet à la fois :
- d'exercer une force d'appui pouvant compenser, si nécessaire, la force de rappel exercée par les éléments ressorts 220 sur chaque transistor THi, TLi. Les contacts électriques entre les transistors et les éléments ressorts 220 sont ainsi optimisés. Cependant, les éléments ressorts 220 peuvent être configurés pour exercer une pression contrôlée sur chaque transistor THi, TLi, permettant de les maintenir fixes en l'absence de la force d'appui du dispositif de refroidissement 202,
- de maintenir un contact mécanique avec la deuxième face 210b de chaque transistor THi, TLi, de manière à refroidir celle-ci.

Divers moyens mécaniques de pression peuvent être envisagés afin de maintenir et/ou compléter la pression exercée par le dispositif de refroidissement 202 sur les composants. Ainsi sur la Figure 4E, un ensemble de vis 202a et écrous 202b permettent la fixation du dispositif de refroidissement 202 au travers de trous 205b, 201e ménagés dans le dispositif de refroidissement 202, dans le cadre de refroidissement 202 et dans le support électrique 201. Néanmoins, d'autres moyens de fixation peuvent être envisagés, par exemple un dispositif de fixation par clipsage. Une interface thermique est placée entre chaque transistor THi, TLi et le dispositif de refroidissement 202 afin d'améliorer le refroidissement de chaque transistor.

La Figure 5 est une vue de dessous de la Figure 4E, illustrant le module 200 électronique de puissance obtenu après assemblage. On y observe notamment la présence de connecteurs permettant un raccordement électrique aux sorties U, V, W des bras d'onduleur 301-i, aux potentiels bas et haut de bus L, H, ainsi que le connecteur peigne 201d pour la commande des transistors THi, TLi.

Le module 200 électronique de puissance décrit ci-dessus présente les avantages suivants. Les électrodes 210c de chaque composant 210 sont toutes orientées selon une même face, à savoir la première face 210a, tandis que la deuxième face 210b de chaque composant 210 est destinée au refroidissement du composant. Les éléments ressorts 220 permettent le raccordement électrique des électrodes 210c avec le support électrique 201 en exerçant une pression contrôlée sur les composants 210, permettant de les maintenir fixe. Il est ainsi possible, vis-à-vis de l'état de l'art, de s'affranchir de l'utilisation de fils de câblage métallique 104 ainsi que du report des composants sur des joints d'interconnexions. Il est ainsi possible de réduire les inductances parasites et de s'affranchir des risques de défaillances liés aux fils et joints pouvant être observés au cours des différents cycles thermiques. La fiabilité du module 200 électronique de puissance s'en voit donc renforcée.

Par ailleurs, le contact électrique entre chaque composant 210 et le support électrique 201 est établi par simple mise en appui des électrodes 210c des composants 210 sur les éléments ressorts 220. Le contact mécanique et électrique entre les composants 210 et les éléments ressort 220 est complété par une force d'appui exercée par le dispositif de refroidissement 202 sur la deuxième face 210b de chaque composant 210. Ainsi, en cas de défaillance d'un composant spécifique, le module 200 et facilement démontable, le composant défaillant accessible et remplaçable par simple retrait. Le module 200 présente ainsi une haute maintenabilité. Cette facilité de maintenance du module 200 autorise l'ajout de composants supplémentaires, ou le remplacement spécifique de composant(s) sans pour autant impliquer de complexité d'assemblage, lui conférant ainsi un caractère modulaire. Il est ainsi possible de cibler en termes d'applications diverses gammes de puissance, notamment les faibles et/ou moyennes puissances.

## Revendications

1. Module (200) électronique de puissance comprenant une pluralité de composants (210) électroniques de puissance à semi-conducteur reliés électriquement à un support électrique (201), et un dispositif de refroidissement (202) en contact thermique avec chaque composant (210), **caractérisé en ce que** chaque composant (210) est présent entre le support électrique (201) et le dispositif de refroidissement (202), et **en ce que** chaque composant (210) est monté sur le support électrique (201) via au moins un élément ressort (220) électriquement conducteur.

2. Module (200) selon la revendication 1, dans lequel chaque composant (210) comprend une première face (210a) disposée en regard du support électrique (201), la dite première face comportant des électrodes (210c), et ledit au moins un élément ressort (220) établissant un raccord électrique entre au moins une des électrodes (210c) et le support électrique (201).

3. Module (200) selon la revendication 2, dans lequel chaque composant (210) comprend une seconde face (210b) opposée à la première face (210a), le module (200) comprenant en outre une interface thermique (203) disposée entre le dispositif de refroidissement (202) et la seconde face (210b) de chaque composant (210).

4. Module (200) selon la revendication 3, dans lequel ledit au moins un élément ressort (220) établissant un raccord électrique entre ladite au moins une des électrodes (210c) et le support électrique (201) comprend une première extrémité (220a) brasée sur le support électrique (201).

5. Module (200) selon la revendication 4, dans lequel ledit au moins un élément ressort (220) comprend une seconde extrémité (220b) venant en appui sur ladite au moins une des électrodes (210c).

6. Module (200) selon l'une quelconque des revendications 1 à 5, dans lequel chaque composant (210) est conditionné dans un boitier électronique à montage de surface.

7. Module (200) selon l'une quelconque des revendications 1 à 6, comprenant en outre un cadre de positionnement (205) disposé entre le support électrique (201) et le dispositif de refroidissement (202) et comprenant des orifices (205a) traversants configurés chacun pour recevoir respectivement un composant (210) et au moins un élément ressort (220).

8. Module (200) selon l'une quelconque des revendications 1 à 7, dans lequel ledit au moins un composant (210) est un transistor de puissance ou une diode de puissance.

9. Module (200) selon l'une quelconque des revendications 1 à 8, comprenant un convertisseur de puissance formé par une pluralité de composants (210).

## Patentansprüche

1. Leistungselektronikmodul (200), das eine Vielzahl von elektronischen Halbleiter-Leistungskomponenten (210), die elektrisch mit einem elektrischen Träger (201) verbunden sind, und eine Kühlvorrichtung (202) umfasst, die in thermischem Kontakt mit jeder Komponente (210) ist, **dadurch gekennzeichnet, dass** jede Komponente (210) zwischen dem elektrischen Träger (201) und der Kühlvorrichtung (202) vorhanden ist, und dadurch, dass jede Komponente (210) über mindestens ein elektrisch leitfähiges Federelement (220) auf dem elektrischen Träger (201) montiert ist.

2. Modul (200) nach Anspruch 1, wobei jede Komponente (210) eine erste Fläche (210a) umfasst, die dem elektrischen Träger (201) gegenüberstehend angeordnet ist, wobei die erste Fläche Elektroden (210c) umfasst, und das mindestens eine Federelement (220) eine elektrische Verbindung zwischen mindestens einer der Elektroden (210c) und dem elektrischen Träger (201) herstellt.

3. Modul (200) nach Anspruch 2, wobei jede Komponente (210) eine zweite Fläche (210b) umfasst, die der ersten Fläche (210a) entgegengesetzt ist, wobei das Modul (200) ferner eine thermische Grenzschicht (203) umfasst, die zwischen der Kühlvorrichtung (202) und der zweiten Fläche (210b) jeder Komponente (210) angeordnet ist.

4. Modul (200) nach Anspruch 3, wobei das mindestens eine Federelement (220), das eine elektrische Verbindung zwischen der mindestens einen von den Elektroden (210c) und dem elektrischen Träger (201) herstellt, ein erstes Ende (220a) umfasst, das an den elektrischen Träger (201) gelötet ist.

5. Modul (200) nach Anspruch 4, wobei das mindestens eine Federelement (220) ein zweites Ende (220b) umfasst, das auf mindestens einer der Elektroden (210c) in Anlage kommt.

6. Modul (200) nach einem der Ansprüche 1 bis 5, wobei jede Komponente (210) in einem oberflächenmontierten elektronischen Gehäuse verpackt ist.

7. Modul (200) nach einem der Ansprüche 1 bis 6, das ferner einen Positionierungsrahmen (205) umfasst, der zwischen dem elektrischen Träger (201) und der Kühlvorrichtung (202) angeordnet ist und Durchgangsöffnungen (205a) umfasst, die jeweils ausgestaltet sind, um respektive eine Komponente (210) und mindestens ein Federelement (220) aufzunehmen.

8. Modul (200) nach einem der Ansprüche 1 bis 7, wobei die mindestens eine Komponente (210) ein Leistungstransistor oder eine Leistungsdiode ist.

9. Modul (200) nach einem der Ansprüche 1 bis 8, das einen Leistungswandler umfasst, der aus einer Vielzahl von Komponenten (210) besteht.

## Claims

1. A Power electronic module (200) comprising a plurality of semiconductor power electronic components (210) electrically connected to an electrical support (201), and a cooling device (202) in thermal contact with each component (210), **characterized in that** each component (210) is present between the electrical support (201) and the cooling device (202), and **in that** each component (210) is mounted on the electrical support (201) via at least one electrically conductive spring element (220).

2. The module (200) according to claim 1, wherein each component (210) comprises a first side (210a) disposed facing the electrical support (201), said first side including electrodes (210c), and said at least one spring element (220) establishing an electrical connection between at least one of the electrodes (210c) and the electrical support (201).

3. The module (200) according to claim 2, wherein each component (210) comprises a second side (210b) opposite the first side (210a), the module (200) further comprising a thermal interface (203) disposed between the cooling device (202) and the second side (210b) of each component (210).

4. The module (200) according to claim 3, wherein said at least one spring element (220) establishing an electrical connection between said at least one of the electrodes (210c) and the electrical support (201) comprises a first end (220a) brazed to the electrical support (201).

5. The module (200) according to claim 4, wherein said at least one spring element (220) comprises a second end (220b) bearing on said at least one of the electrodes (210c).

6. The module (200) according to any one of claims 1 to 5, wherein each component (210) is packaged in an electronic surface-mounted package.

7. The module (200) according to any one of claims 1 to 6, further comprising a positioning frame (205) disposed between the electrical support (201) and the cooling device (202) and comprising through orifices (205a) each configured to receive respectively a component (210) and at least one spring element (220).

8. The module (200) according to any one of claims 1 to 7, wherein said at least one component (210) is a power transistor or a power diode.

9. The module (200) according to any one of claims 1 to 8, comprising a power converter formed by a plurality of components (210).
